# FASCICULE DE BREVET EUROPEEN

(11) **EP 1 950 641 B1**
(45) Date de publication et mention de la délivrance du brevet: **07.04.2010**
(21) Numéro de dépôt: 08100996.1
(22) Date de dépôt: 28.01.2008
(51) Int. Cl.: G06F 1/16, H05K 7/14

(54) **Module d'alimentation électrique d'un châssis de cartes électroniques**
Elektrisches Versorgungsmodul für einem Chassis von Elektronikkarten
Electrical supply module for a chassis receiving electronic cards

(30) Priorité: 29.01.2007 FR 0752925
(43) Date de publication de la demande: 30.07.2008
(73) Titulaire: Alcatel Lucent, 75008 Paris (FR)
(72) Inventeur: Odabachian, Robin, 22560, Trebeurden (FR); Peron, Daniel, 22300, Lannion (FR); Crehan, Daniel, 22300, Lannion (FR)
(74) Mandataire: Sciaux, Edmond

(56) Documents cités:
- EP-A- 0 735 810
- US-A- 6 081 419
- US-A1- 2004 117 681
- US-A1- 2006 139 904

## Description

L'invention concerne un module d'alimentation électrique d'un châssis de cartes électroniques. Elle concerne également un châssis de cartes électroniques équipé d'un tel module d'alimentation. Elle est plus particulièrement applicable à un châssis de cartes désignées couramment dans la technique sous l'appellation cartes ATCA (Advanced Telecom Computer Architecture).

### ETAT DE LA TECHNIQUE

De manière générale, dans un châssis de cartes d'électronique, la connexion de l'alimentation électrique du châssis et les dispositifs de filtrage de l'alimentation sont généralement situés du côté du fond du châssis appelé fond de panier. La connexion de l'alimentation et les moyens de filtrage ne sont pas accessibles à partir du panneau avant du châssis ou y sont difficilement accessibles.

Le document EP 0 735 810 décrit un châssis de cartes destiné à recevoir un ensemble de cartes de circuits électroniques. Ce châssis comporte une carte de fond de panier qui est située à proximité de la paroi arrière du châssis, et parallèle à cette paroi arrière. Cette carte de fond de panier est munie de connecteurs dans lesquels des cartes de circuits électroniques sont embrochées. Parmi ces cartes, il y a une carte de circuits d'alimentation, disposée horizontalement, et parallèlement aux autres cartes de circuits électroniques. Cette carte de circuits d'alimentation est connectée au fond de panier par un connecteur d'alimentation fixé sur la carte de fond de panier et dans lequel la carte de circuits d'alimentation est embrochée. L'énergie est fournie par un câble connecté à un dispositif de connexion sur la paroi arrière du châssis. Un autre câble relie ce dispositif de connexion, sur la paroi arrière du châssis, à la carte mère.

Par ailleurs, les châssis de types connus nécessitent généralement un précablage de l'alimentation électrique.

L'objet de l'invention est de permettre une connexion de l'alimentation électrique sur la face avant du châssis sans augmenter les dimensions (hauteur et largeur) du châssis et sans réduire les sections des entrées d'air nécessaires à une bonne ventilation du châssis et donc sans dégrader les performances thermiques de l'ensemble.

L'objet de l'invention est donc de résoudre ces problèmes.

### RESUME DE L'INVENTION

L'invention concerne donc un module d'alimentation électrique d'un châssis de cartes destiné à recevoir un ensemble de cartes de circuits électroniques ce châssis comportant deux montants constituant les bords verticaux de la face avant du châssis, et comportant au moins une carte de fond de panier située à proximité de la face arrière du châssis, cette carte de fond de panier étant munie de connecteurs dans lesquels des cartes de circuits électroniques peuvent être embrochées ; ce module d'alimentation comportant au moins une carte de circuits d'alimentation disposée parallèlement auxdites cartes de circuits électroniques et pouvant être embrochée sur un connecteur fixé sur la carte de fond de panier ;
**caractérisé en ce que** ladite carte de circuits d'alimentation est apte à être disposée à proximité d'une des parois latérales d'un châssis de cartes ;
et en ce qu'une extrémité de ladite carte de circuits d'alimentation est adaptée pour dépasser de la face avant d'un châssis de cartes, et comporte un dispositif de connexion apte à être fixé sur un montant de la face avant d'un châssis de cartes, et apte à être connecté à un câble d'alimentation.

Selon l'invention, ce module d'alimentation comporte:
- au moins un dispositif de connexion électrique fixé sur la paroi avant du châssis,
- au moins une carte de circuits d'alimentation disposée parallèlement auxdites cartes de circuits électroniques et connectée audit dispositif de connexion électrique,
- au moins un connecteur d'alimentation fixé sur la carte de fond de panier et dans lequel la carte de circuits d'alimentation est destinée à être embrochée.

Selon une forme de réalisation préférée de l'invention ladite carte de circuits d'alimentation est disposée à proximité d'une des parois latérales du châssis.

Egalement, selon une forme de réalisation préférée de l'invention, cette carte de circuits d'alimentation est disposée dans la partie basse du châssis.

Par ailleurs selon une forme de réalisation avantageuse de l'invention, ladite carte de circuits d'alimentation est disposée au dessous d'une carte de gestion permettant de commander ledit ensemble de cartes électroniques.

De façon générale cette carte de circuits d'alimentation est de préférence placée sous une carte d'électronique présentant peu d'échauffement et ne nécessitant que peu ou pas de ventilation.

De préférence, on prévoira que ladite carte de circuits d'alimentation est disposée entre un module de ventilation situé en bas du châssis et une paroi latérale du châssis.

Selon une forme de réalisation préférée de l'invention, le dispositif de connexion électrique comporte deux pièces en formes générales d'équerres dont une première branche de chacune d'elles est fixée à la paroi avant du châssis par l'intermédiaire de pièces isolantes et auxquelles un câble d'alimentation électrique doit être connecté. La carte de circuits d'alimentation est destinée à être connectée à la deuxième branche de chaque pièce en forme d'équerre.

Dans cette forme de réalisation, ladite carte de circuits d'alimentation électrique est alors destinée à être connectée à la deuxième branche de chaque pièce en forme d'équerre à l'aide d'un dispositif de fixation qui permet également de fixer la carte de circuits d'alimentation au châssis.

Selon une variante de réalisation de l'invention, le module d'alimentation électrique selon l'invention comporte:
- deux dispositifs de connexions électriques fixés chacun sur la paroi avant du châssis
- deux cartes de circuits d'alimentation disposées de part et d'autre du module de ventilation et connectées chacune à un dispositif de connexion électrique. Une première carte de circuits d'alimentation est disposée parallèlement et à proximité de la paroi latérale gauche du châssis et une deuxième carte de circuits d'alimentation est disposée parallèlement et à proximité de la paroi latérale droite du châssis,
- deux connecteurs d'alimentation fixés sur la carte de fond de panier destinés chacun à recevoir une carte de circuits d'alimentation.

L'invention est également applicable à un châssis de cartes électroniques comprenant au moins un module d'alimentation ainsi décrit. Il comporte alors un dispositif de connexion sur la face avant du châssis, une carte de circuits d'alimentation connectée au dispositif de connexion, un connecteur d'alimentation fixé à une carte de fond de panier du châssis et dans lequel est embrochée la carte de circuits d'alimentation.

Avantageusement, le dispositif de connexion permet de réaliser une connexion d'une carte de circuits d'alimentation électrique au châssis et permet également d'immobiliser également cette carte dans le châssis.

Selon une variante de réalisation, ledit châssis comporte deux cartes de circuits d'alimentation situées de part et d'autre du module de ventilation et au dessous de l'ensemble de cartes électroniques. Chaque carte de circuits d'alimentation est alors connectée électriquement à un dispositif de connexion qui est fixé sur un montant du panneau avant du châssis.

### BREVE DESCRIPTION DES FIGURES

Les différents objets et caractéristiques de l'invention apparaîtront plus clairement dans la description qui va suivre et dans les figures annexées qui représentent:
- la figure 1, une vue en perspective d'un exemple de réalisation schématique d'un châssis selon l'invention,
- la figure 2, un exemple de réalisation d'un module d'alimentation électrique d'un châssis de cartes électroniques selon l'invention,
- la figure 3, une vue de détail en perspective d'un dispositif de connexion du module d'alimentation selon l'invention.

### DESCRIPTION DETAILLEE

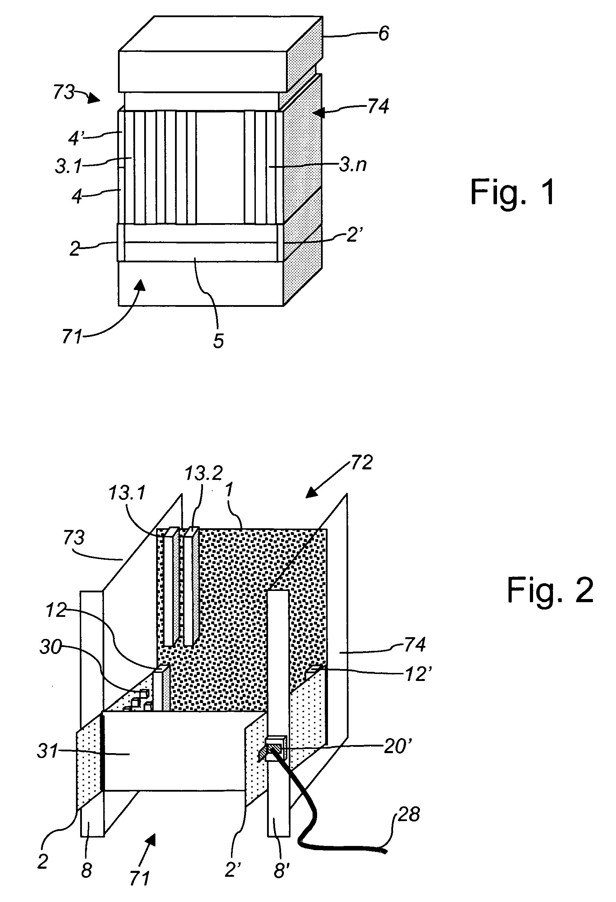

En se reportant à la figure 1, on va donc décrire un exemple de réalisation de base d'un module d'alimentation électrique d'un châssis selon l'invention.

Le châssis de la figure 1 comporte une partie centrale destinée à recevoir un ensemble de cartes électroniques 3.1 à 3.n disposées verticalement dans le châssis. Avantageusement ces cartes sont de type connu sous l'appellation normalisée ATCA (Advanced Telecom Computer Architecture). A titre indicatif ces cartes sont normalement au nombre de 14.

Au dessous de cet ensemble de cartes est prévus une entrée d'air de refroidissement comportant en principe un système de ventilation 5 capable d'injecter un air de refroidissement dans le châssis. Au dessus de l'ensemble de cartes est prévu un dispositif de sortie de l'air de refroidissement.

Selon l'invention, on prévoit au moins un module d'alimentation localisé le long de l'une des parois latérales 73 ou 74 du châssis. Ce module d'alimentation comporte les dispositifs de filtrages nécessaires à une alimentation correcte et fiable du châssis.

Avantageusement, ce module est placé sous l'ensemble de cartes 3.1 à 3.n et plus particulièrement, sous une carte présentant un faible dégagement de chaleur pour le cas où le module de circuit d'alimentation constituerait un obstacle à la ventilation pour le refroidissement de cette carte.

Sur la figure 1, on a prévu deux modules d'alimentation 2 et 2' localisés respectivement contre la paroi de 73 et contre la paroi 74 du châssis.

De préférence, la carte de circuits d'alimentation 2 est située sous les cartes de gestion 4 et 4' de l'ensemble de cartes électroniques 3.1 à 3.n. Les cartes de gestion 4, 4' peuvent être des cartes appelées SHMC (Shelf Management Controler) dans la technologie anglo-saxonne. La carte de gestion 4 sera organisée de façon que les circuits susceptibles de présenter le plus d'échauffement soient disposés à la partie supérieure de la carte pour éviter que leur refroidissement soit gêné par la carte de circuits d'alimentation 2 si cette gêne pouvait éventuellement exister. Pour la même raison, la carte de circuits d'alimentation 2' sera placée sous une carte ne présentant que peu ou pas d'échauffement.

La connexion de ces modules d'alimentation est accessible sur le panneau avant 71 du châssis. De plus, ces modules d'alimentation permettent d'amener l'alimentation électrique à partir du panneau avant vers l'arrière et notamment vers une carte de distribution ou fond de panier localisé à l'arrière du châssis.

La figure 2 représente une vue partielle interne d'un châssis comprenant un mode de réalisation d'un module d'alimentation selon l'invention. Sur cette figure les cartes de circuits électroniques 3.1 à 3.n n'ont pas été représentées.

Comme sur la figure 1, ce châssis comporte deux modules d'alimentation.

Chaque module d'alimentation comporte une carte de circuits d'alimentation 2, 2'. La carte 2 est située le plus près possible de la paroi 73 du châssis et la carte 2' est située le plus près possible de la paroi 74 du châssis. Chaque carte de circuits d'alimentation est connectée à un dispositif de connexion tel que le dispositif 20' pour la carte 2'.

Les cartes 2 et 2' sont enfichées dans des connecteurs 12, 12' qui sont fixés sur la carte de fond de panier 1. Celle-ci permet de distribuer l'alimentation électrique aux différents connecteurs des cartes électroniques telles que 13.1 et 13.2. Les connecteurs 12 et 12' sont choisis de façon que les cartes de circuits d'alimentation soient le plus près des parois latérales de droite et de gauche du châssis.

Par ailleurs, les cartes 2 et 2' sont connectées électriquement à un dispositif de connexion électrique situés sur la face avant du châssis. C'est ainsi que sur la figure 2, un dispositif de connexion électrique 20' est fixé sur le montant de droite 8' de la face avant 71 du châssis. La carte 2' est connectée à ce dispositif de connexion 20'.

L'alimentation électrique du châssis est assurée en connectant au dispositif de connexion électrique, un câble 28 qui est par ailleurs connecté à une source de courant d'alimentation.

Comme on peut le voir sur la figure 2, les cartes de circuits d'alimentation comportent des composants (composants de filtrage) tel que le composant 30 de la carte 2.

Par ailleurs, les cartes de circuits d'alimentation sont disposées de part et d'autre d'un module de ventilation 5 situé en bas du châssis.

On peut également prévoir avantageusement une plaque 31 située devant le module de ventilation et entre les cartes de circuits d'alimentation 2 et 2'. Cette plaque 31 sert de protection et d'écran aux ondes électromagnétiques.

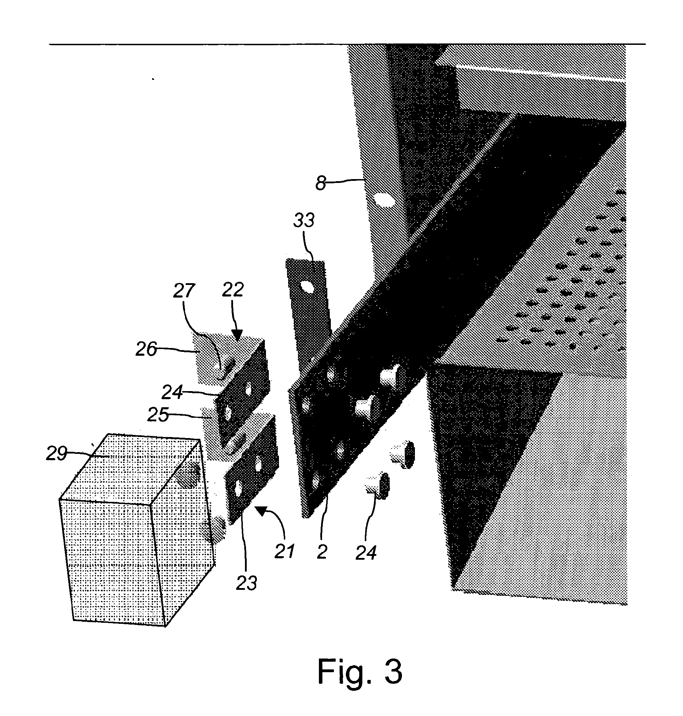

La figure 3 représente plus en détail et en perspective éclatée, un mode de réalisation d'un dispositif de connexion de la figure 2.

On retrouve sur cette figure, le montant de gauche 8 de la face avant du châssis ainsi que la plaque de circuits d'alimentation électrique 2.

Deux pièces de connexion en matériau conducteur 21 et 22 sont destinées à être fixées au montant 8 avec une lame isolante 33 placée entre les pièces de connexion et le montant 8.

Avantageusement, les pièces de connexions 21 et 22 sont en cuivre et se présentent sous la forme d'équerres. La fixation des branches 25 et 26 de ces équerres au montant 8 peut se faire par tout moyen tel que rivets ou à l'aide de vis.

On peut également prévoir avantageusement que deux fils de phase du câble d'alimentation 28 de la figure 2 sont connectés aux branches 25 et 26 des équerres.

Les équerres 20 et 21 étant fixées au montant 8, l'ensemble de cartes et notamment les cartes de circuits d'alimentation tel que la carte 2 peuvent être montées dans le châssis.

La carte 2 est embrochée dans le connecteur 12 de la figure 2. La carte 2 est ensuite connectée électriquement aux branches 23 et 24 des équerres 21 et 22.

Avantageusement, cette connexion se fait à l'aide de vis et écrous, de telle façon que les vis, telle que 24, traversent la carte 2 et les branches 23 et 24 des équerres. La carte 2 est donc fixée au montant 8 du châssis par l'intermédiaire des équerres 21 et 22.

Ainsi, la connexion de la carte 2 aux équerres établit l'alimentation électrique dans le châssis et immobilise également la carte 2 dans le châssis.

Par ailleurs, on pourra prévoir avantageusement un dispositif de protection 29 qui sera placé sur les équerres pour éviter tout contact des équerres par un utilisateur.

L'invention présente les avantages suivants:
- possibilité de réaliser un châssis moins profond,
- enfichage des cartes de circuits d'alimentation 2 et 2' dans les connecteurs de fond de panier du châssis, ce qui permet leur extraction par l'avant du châssis,
- possibilité, lorsqu'on enlève l'une des cartes de circuits d'alimentation, de maintenir le châssis alimenté par l'autre carte de circuits d'alimentation.
- accès par l'arrière du châssis inutile,
- possibilité de monter le châssis contre un mur.

## Revendications

1. Module d'alimentation électrique d'un châssis de cartes destiné à recevoir un ensemble de cartes de circuits électroniques (3.1 à 3.n), ce châssis comportant deux montants (8, 8') constituant les bords verticaux de la face avant (71) du châssis, et comportant au moins une carte de fond de panier (1) située à proximité de la face arrière (72) du châssis, cette carte de fond de panier étant munie de connecteurs (13.1 à 13.2) dans lesquels des cartes de circuits électroniques (3.1 à 3.n) peuvent être embrochées ; ce module d'alimentation comportant au moins une carte de circuits d'alimentation (2') disposée parallèlement auxdites cartes de circuits électroniques (3.1 à 3.n) et pouvant être embrochée sur un connecteur (12') fixé sur la carte de fond de panier (1) ;
**caractérisé en ce que** ladite carte de circuits d'alimentation (2') est apte à être disposée à proximité d'une des parois latérales (74) d'un châssis de cartes ;
et **en ce qu'**une extrémité de ladite carte de circuits d'alimentation est adaptée pour dépasser de la face avant d'un châssis de cartes, et comporte un dispositif de connexion (20') apte à être fixé sur un montant (8') de la face avant d'un châssis de cartes, et apte à être connecté à un câble d'alimentation (28).

2. Module d'alimentation électrique selon la revendication 1, **caractérisé en ce que** ladite carte de circuits d'alimentation (2, 2') est disposée dans la partie basse du châssis.

3. Module d'alimentation électrique selon la revendication 2, **caractérisé en ce que** ladite carte de circuits d'alimentation (2, 2') est apte à être disposée au dessous d'une carte de gestion (4, 4') dudit ensemble de cartes électroniques permettant de commander ledit ensemble de cartes électroniques (3.1 à 3.n).

4. Module d'alimentation électrique selon la revendication 3, **caractérisé en ce que** ladite carte de circuits d'alimentation (2, 2') est apte à être disposée entre un module de ventilation (5) et une paroi latérale (73, 74) du châssis.

5. Module d'alimentation électrique selon la revendication 4, **caractérisé en ce que** le dispositif de connexion électrique (20) comporte deux pièces en formes générales d'équerres dont une première branche (25, 26) de chacune d'elles est apte à être fixée à la paroi avant (71) du châssis par l'intermédiaire de pièces isolantes (33) et auxquelles un câble d'alimentation électrique peut être connecté, ladite carte de circuits d'alimentation étant apte à être connectée à la deuxième branche (23, 24) de chaque pièce en forme d'équerre.

6. Module d'alimentation électrique selon la revendication 5, **caractérisé en ce que** ladite carte de circuits d'alimentation électrique (2, 2') est apte à être connectée à la deuxième branche (23, 24) de chaque pièce en forme d'équerre (21, 22) à l'aide d'un dispositif de fixation qui permet également de fixer la carte de circuits d'alimentation à un châssis

7. Module d'alimentation électrique selon l'une quelconque des revendications précédentes, **caractérisé en ce qu'**il comporte deux cartes de circuits d'alimentation (2, 2'), une première carte de circuits d'alimentation (2) étant apte à être disposée parallèlement et à proximité de la paroi latérale gauche (73) d'un châssis, et une deuxième carte de circuits d'alimentation (2') étant apte à être disposée parallèlement et à proximité de la paroi latérale droite (74) d'un châssis,
et **en ce que** chaque carte de circuits d'alimentation (2, 2') comporte un dispositif de connexion électrique (20, 20'), apte à être fixé respectivement sur le montant droit et le montant gauche de la face avant (71) d'un châssis.

8. Châssis de cartes électroniques comprenant au moins un module d'alimentation selon l'une quelconque des revendications précédentes.

9. Châssis de cartes électroniques selon la revendication 9, **caractérisé en ce qu'**il comporte un module d'alimentation comportant deux cartes de circuits d'alimentation (2, 2') aptes à être situées de part et d'autre d'un module de ventilation (5) et au dessous d'un ensemble de cartes électroniques (3.1 à 3.n), chaque carte de circuits d'alimentation comportant un dispositif de connexion (20, 20') qui est apte à être fixé sur un montant (8, 8') de la face avant du châssis.

## Claims

1. Power supply module for a rack of boards intended to receive a set of electronic circuit boards (3.1 to 3.n), said rack comprising two columns (8, 8') constituting the vertical edges of the front face (71) of the rack, and comprising at least one backplane (1) located close to the rear face (72) of the rack, said backplane being equipped with connectors (13.1 to 13.2) in which electronic circuit boards (3.1 to 3.n) can be connected; said supply module comprising at least one supply circuit board (2') arranged in parallel with said electronic circuit boards (3.1 to 3.n) and which can be connected to a connector (12') fixed to the backplane (1);
**characterized in that** said supply circuit board (2') can be arranged close to one of the side walls (74) of a rack of boards;
and **in that** one end of said supply circuit board is adapted to exceed the front face of a rack of boards, and comprises a connection device (20') which can be fixed to a column (8') of the front face of a rack of boards, and can be connected to a supply cable (28).

2. Power supply module according to claim 1, **characterized in that** said supply circuit board (2, 2') is arranged in the lower part of the rack.

3. Power supply module according to claim 2, **characterized in that** said supply circuit board (2, 2') can be arranged below a management board (4, 4') of said set of electronic boards used to control said set of electronic boards (3.1 to 3.n).

4. Power supply module according to claim 3, **characterized in that** said supply circuit board (2, 2') can be arranged between a ventilation module (5) and a side wall (73, 74) of the rack.

5. Power supply module according to claim 4, **characterized in that** the power connection device (20) comprises two parts, generally square in shape, of which a first branch (25, 26) of each of them can be attached to the front wall (71) of the rack through isolating parts (33) and to which a power supply cable can be connected, said supply circuit board being able to be connected to the second branch (23, 24) of each square-shaped part.

6. Power supply module according to claim 5, **characterized in that** said power supply circuit board (2, 2') can be connected to the second branch (23, 24) of each square-shaped part (21, 22) using an attachment device which can also be used to attach the supply circuit board to a rack.

7. Power supply module according to any of the previous claims, **characterized in that** it comprises two supply circuit boards (2, 2'), a first supply circuit board (2) which can be arranged in parallel and close to the left-hand side wall (73) of a rack, and a second supply circuit board (2') which can be arranged in parallel and close to the right-hand side wall (74) of a rack,
and **in that** each supply circuit board (2, 2') comprises a power connection device (20, 20'), which can be attached respectively to the right-hand column and left-hand column of the front face (71) of a rack.

8. Rack of electronic boards comprising at least one supply module according to any of the previous claims.

9. Rack of electronic boards according to claim 9, **characterized in that** it comprises a supply module comprising two supply circuit boards (2, 2') which can be located either side of a ventilation module (5) and below a set of electronic boards (3.1 to 3.n), each supply circuit board comprising a connection device (20, 20') which can be attached to a column (8, 8') of the front face of the rack.

## Patentansprüche

1. Stromversorgungsmodul eines Platinen-Chassis, welches für die Aufnahme einer Gruppe von elektronischen Leiterplatten (3.1 bis 3.n) bestimmt ist, wobei dieses Chassis zwei Stützen (8, 8'), welche die vertikalen Kanten der Vorderseite (71) des Chassis bilden, und mindestens eine in Nähe der Rückseite (72) des Chassis angeordnete Rückwandplatine (1) umfasst, wobei diese Rückwandplatine Steckverbinder (13.1 bis 13.2) aufweist, in welche elektronische Leiterplatten (3.1 bis 3.n) gesteckt werden können; wobei dieses Stromversorgungsmodul mindestens eine Stromversorgungsleiterplatte (2') umfasst, welche parallel zu den besagten elektronischen Leiterplatten (3.1 bis 3.n) angeordnet ist und auf einen auf der Rückwandplatine (1) befestigten Steckverbinder (12') gesteckt werden kann;
**dadurch gekennzeichnet, dass** die besagte Stromversorgungsleiterplatte (2') in der Nähe einer der Seitenwände (74) eines Platinen-Chassis angeordnet werden kann;
und dass ein Ende der besagten Stromversorgungsleiterplatte so gestaltet ist, dass es die Vorderseite eines Platinen-Chassis überragt, und dass es eine Verbindungsvorrichtung (20') umfasst, welche auf einer Stütze (8') der Vorderseite eines Platinen-Chassis befestigt und mit einem Stromversorgungskabel (28) verbunden werden kann.

2. Stromversorgungsmodul nach Anspruch 1, **dadurch gekennzeichnet, dass** die besagte Stromversorgungsleiterplatte (2, 2') im unteren Teil des Chassis angeordnet ist.

3. Stromversorgungsmodul nach Anspruch 2, **dadurch gekennzeichnet, dass** die besagte Stromversorgungsleiterplatte (2, 2') so gestaltet ist, dass sie unter einer Verwaltungsplatine (4, 4') der besagten Gruppe von Elektronikplatinen, welche die Steuerung der besagten Gruppe von Elektronikplatinen (3.1 bis 3.n) ermöglicht, angeordnet werden kann.

4. Stromversorgungsmodul nach Anspruch 3, **dadurch gekennzeichnet, dass** die besagte Stromversorgungsleiterplatte (2, 2') so gestaltet ist, dass sie zwischen einem Lüftungsmodul (5) und einer Seitenwand (73, 74) des Chassis angeordnet werden kann.

5. Stromversorgungsmodul nach Anspruch 4, **dadurch gekennzeichnet, dass** die elektrische Verbindungsvorrichtung (20) zwei im Wesentlichen winkelförmige Teile umfasst, wobei ein erster Schenkel (25, 26) eines jeden winkelförmigen Teils so gestaltet ist, dass er anhand von Isolierteilen (33), an welche ein Stromversorgungskabel angeschlossen werden kann, an der Vorderwand (71) des Chassis befestigt werden kann, wobei die besagte Stromversorgungsleiterplatte so gestaltet ist, dass sie an den zweiten Schenkel (23, 24) eines jeden winkelförmigen Teils angeschlossen werden kann.

6. Stromversorgungsmodul nach Anspruch 5, **dadurch gekennzeichnet, dass** die besagte Stromversorgungsleiterplatte (2,2') so gestaltet ist, dass sie anhand einer Befestigungsvorrichtung, welche ebenfalls das Befestigen der Stromversorgungsleiterplatte an ein Chassis ermöglicht, an den zweiten Schenkel (23, 24) eines jeden winkelförmigen Teils (21, 22) angeschlossen werden kann.

7. Stromversorgungsmodul nach einem beliebigen der vorstehenden Ansprüche, **dadurch gekennzeichnet, dass** es zwei Stromversorgungsleiterplatten (2, 2') aufweist, wobei eine erste Stromversorgungsleiterplatte (2) so gestaltet ist, dass sie parallel zu und in Nähe der linken Seitenwand (73) eines Chassis angeordnet werden kann, und eine zweite Stromversorgungsleiterplatte (2') so gestaltet ist, dass sie parallel zu und in Nähe der rechten Seitenwand (74) eines Chassis angeordnet werden kann,
und dass jede Stromversorgungsleiterplatte (2, 2') eine elektrische Verbindungsvorrichtung (20, 20') aufweist, welche jeweils auf der rechten Stütze und auf der linken Stütze der Vorderseite (71) eines Chassis befestigt werden kann.

8. Elektronikplatinen-Chassis mit mindestens einem Stromversorgungsmodul nach einem beliebigen der vorstehenden Ansprüche.

9. Elektronikplatinen-Chassis nach Anspruch 8, **dadurch gekennzeichnet, dass** es ein Stromversorgungsmodul mit zwei Stromversorgungsleiterplatten (2, 2') umfasst, welche an beiden Seiten eines Lüftungsmoduls (5) und unter einer Gruppe von Elektronikplatinen (3.1 bis 3.n) angeordneten werden können, wobei jede Stromversorgungsleiterplatte eine Verbindungsvorrichtung (20, 20') aufweist, welche auf einer Stütze (8, 8') der Vorderseite des Chassis befestigt werden kann.
